(19) Europäisches Patentamt

European Patent Office

Office européen des brevets

(11) **EP 1 620 950 B1**

(12) **EUROPÄISCHE PATENTSCHRIFT**

(45) Veröffentlichungstag und Bekanntmachung des Hinweises auf die Patenterteilung:
**18.10.2006 Patentblatt 2006/42**

(51) Int Cl.:
*H03M 7/32* *(2006.01)*        *H03M 7/36* *(2006.01)*
*H03K 7/00* *(2006.01)*

(21) Anmeldenummer: **04731357.2**

(22) Anmeldetag: **06.05.2004**

(86) Internationale Anmeldenummer:
**PCT/EP2004/004845**

(87) Internationale Veröffentlichungsnummer:
**WO 2004/100382 (18.11.2004 Gazette 2004/47)**

(54) **PULSMODULATOR UND VERFAHREN ZUR PULSMODULATION**

PULSE MODULATOR AND PULSE MODULATION METHOD

MODULATEUR D'IMPULSIONS ET PROCEDE DE MODULATION        D'IMPULSIONS

(84) Benannte Vertragsstaaten:
**AT BE BG CH CY CZ DE DK EE ES FI FR GB GR HU IE IT LI LU MC NL PL PT RO SE SI SK TR**

(30) Priorität: **08.05.2003 DE 10320674**

(43) Veröffentlichungstag der Anmeldung:
**01.02.2006 Patentblatt 2006/05**

(73) Patentinhaber: **LITEF GmbH**
**79115 Freiburg (DE)**

(72) Erfinder: **SPAHLINGER, Günter**
**70188 Stuttgart (DE)**

(74) Vertreter: **Müller, Frithjof E.**
**Müller Hoffmann & Partner**
**Patentanwälte**
**Innere Wiener Strasse 17**
**81667 München (DE)**

(56) Entgegenhaltungen:
**US-B1- 6 317 468**

• **TAO H ET AL: "A 400-MS/S FREQUENCY TRANSLATING BANDPASS SIGMA-DELTA MODULATOR" IEEE JOURNAL OF SOLID-STATE CIRCUITS, IEEE INC. NEW YORK, US, Bd. 34, Nr. 12, Dezember 1999 (1999-12), Seiten 1741-1752, XP000932504 ISSN: 0018-9200**

EP 1 620 950 B1

**Beschreibung**

Die Erfindung betrifft einen Pulsmodulator zur Umwandlung eines komplexen Eingangssignals in ein Pulssignal sowie ein Verfahren zur Pulsmodulation eines komplexen Eingangssignals.

Zur Umsetzung eines digitalen Eingangssignals in ein Analogsignal können Digital-Analog-Wandler eingesetzt werden. Diese Bausteine sind jedoch teuer und benötigen relativ viel elektrische Leistung. Häufig sind mehrere Versorgungsspannungen notwendig. Ein weiterer Nachteil ist, dass sich Digital-Analog-Wandler schlecht zusammen mit der digitalen Elektronik integrieren lassen und dadurch der Miniaturisierung Grenzen setzen.

In vielen Anwendungen werden daher Digital-Analog-Wandler durch digitale Pulsmodulatoren wie beispielsweise Sigma-Delta-Wandler ersetzt. Ein klassischer Sigma-Delta-Modulator umfasst einen Integrierer, der das Differenzsignal zwischen dem Eingangssignal und einem rückgekoppelten quantisierten Signal aufintegriert, sowie einen Quantisierer, der das aufintegrierte Signal quantisiert. Am Ausgang des Quantisierers kann dann ein quantisiertes Pulssignal abgegriffen werden, das als Rückkopplungssignal zum Eingang des Sigma-Delta-Wandlers zurückgeführt wird. Sigma-Delta-Modulatoren zeichnen sich durch eine typische Rauschcharakteristik aus, wobei das Quantisierungsrauschen aus dem niederfrequenten Bereich in der Nähe von $\omega=0$ zu höheren Frequenzen hin verlagert ist. Das im Bereich höherer Frequenzen auftretende Rauschen kann man dann mit Hilfe eines nachgeschalteten Tiefpassfilters unterdrücken. Sigma-Delta-Wandler lassen sich kostengünstig implementieren und können zusammen mit der digitalen Elektronik integriert werden. Allerdings wäre es für manche Anwendungen von Vorteil, wenn sich das Quantisierungsrauschen in höheren Frequenzen gering halten ließe.

In der Patentschrift US 6.317.468 wird einen Pulsmodulator zur Umwandlung eines komplexen Eingangssignals in ein Pulssignal beschrieben mit einer ersten Multiplizierstufe, die das komplexe Eingangssignal mit einem mit einer IF-Trägerfrequenz oszillierenden komplexen Mischsignal multipliziert und so den Realteil eines um die IF-Trägerfrequenz heraufgemischten Eingangssignals erzeugt, und einem Bandpass-Sigma-Delta-Modulator, der den Realteil des um die IF-Trägerfrequenz heraufgemischten Eingangssignals quantisiert. Dieser Sigma-Delta-Modulator umfaßt eine Subtrahierstufe, die aus der Differenz des Realteils und eines Rückkopplungssignals ein Regelabweichungssignal erzeugt, eine Signalumwandlungsstufe, die das Regelabweichungssignal in ein Regelsignal umwandelt, eine Quantisierungsstufe, die das Regelsignal quantisiert und so das Pulssignal erzeugt, und eine Rückkopplungseinheit, welche ausgehend von dem Pulssignal das Rückkopplungssignal für die Subtrahierstufe erzeugt.

Es ist daher Aufgabe der Erfindung, einen Pulsmodulator sowie ein Verfahren zur Pulsmodulation zur Verfügung zu stellen, bei dem sich die spektrale Verteilung des Quantisierungsrauschens flexibel anpassen lässt.

Diese Aufgabe der Erfindung wird durch einen Pulsmodulator zur Umwandlung eines komplexen Eingangssignals in ein Pulssignal gemäß Anspruch 1, durch eine Ansteuerschaltung gemäß Anspruch 16, einen Frequenzgenerator gemäß Anspruch 19 sowie durch ein Verfahren zur Pulsmodulation eines komplexen Eingangssignals gemäß Anspruch 21 gelöst. Anspruch 31 betrifft ein Computerprogrammprodukt zur Ausführung des erfindungsgemäßen Verfahrens.

Der erfindungsgemäße Pulsmodulator zur Umwandlung eines komplexen Eingangssignals in ein Pulssignal umfasst eine Subtrahiererstufe, die aus der Differenz des komplexen Eingangssignals und eines Rückkopplungssignals ein Regelabweichungssignal erzeugt. Des Weiteren umfasst der Pulsmodulator eine Signalumwandlungsstufe, die das Regelabweichungssignal in ein Regelsignal umwandelt. In einer ersten Multiplizierstufe wird das Regelsignal mit einem mit der Frequenz $w_0$ oszillierenden komplexen Mischsignal multipliziert und so mindestens einer von Realteil und Imaginärteil eines um $w_0$ heraufgemischten Regelsignals erzeugt. Darüber hinaus umfasst der Pulsmodulator eine Quantisierungsstufe, die mindestens einen von Realteil und Imaginärteil des um $\omega_0$ heraufgemischten Regelsignals quantisiert und das Pulssignal erzeugt, sowie eine Rückkopplungseinheit, welche ausgehend von dem Pulssignal das Rückkopplungssignal für die Subtrahiererstufe erzeugt.

Die Funktionsweise des erfindungsgemäßen Pulsmodulators, welcher eine vorteilhafte Modifikation eines klassischen Sigma-Delta-Wandlers darstellt, soll im Folgenden ohne Beschränkung der Allgemeinheit für den Beispielfall eines konstant gehaltenen Eingangssignals erläutert werden. Durch die Subtrahiererstufe und die Signalumwandlungsstufe wird dieses Eingangssignal in ein ebenfalls nur schwach zeitveränderliches Regelsignal umgewandelt. Im Unterschied zu klassischen Sigma-Delta-Wandlern wird dieses Regelsignal aber nun durch die erste Multiplizierstufe mit einem komplexen Mischsignal der Frequenz $\omega_0$ multipliziert, um so ein auf die Frequenz $\omega_0$ heraufgemischtes Regelsignal zu erzeugen. Der Realteil oder der Imaginärteil dieses mit der Frequenz $\omega_0$ oszillierenden Regelsignals wird anschließend durch die Quantisierungsstufe quantisiert, so dass man am Ausgang der Quantisierungsstufe ein reellwertiges Pulssignal mit einer dominanten Frequenzkomponente bei der Frequenz $w_0$ erhält. Dieses reellwertige Pulssignal bildet mit Hilfe von positiven oder negativen Pulsen ein sinusoidales Signal der Frequenz $\omega_0$ nach. Dieses Pulssignal stellt gleichzeitig den Ausgangspunkt für die Berechnung des Rückkopplungssignals dar, welches zur Subtrahiererstufe rückgekoppelt wird und dort vom Eingangssignal abgezogen wird, um die Regelabweichung zu ermitteln.

Zur Erzeugung des Pulssignals ist nicht zwingend erforderlich, sowohl den Realteil als auch den Imaginärteil des um $w_0$ heraufgemischten Regelsignals zu berechnen. Wenn das Pulssignal aus dem Realteil des heraufgemischten Regelsignals abgeleitet werden soll, dann muss der Imaginärteil des heraufgemischten Regelsignals nicht zwingend erzeugt werden.

Der wesentliche Vorteil des erfindungsgemäßen Pulsmodulators gegenüber herkömmlichen Sigma-Delta-Modulatoren ist, dass der Bereich des niedrigen Quantisierungsrauschens von dem Niederfrequenzbereich in der Umgebung vom $\omega=0$ zur Arbeitsfrequenz $w_0$ hin verschoben wird. Dies wird durch komplexes Heraufmischen des Regelsignals in der ersten Multipliziererstufe erreicht. Damit erhält man ein Pulssignal, das gerade im relevanten Spektralbereich um $w_0$ herum einen niedrigen Rauschpegel aufweist.

Ausgangspunkt für das Verständnis der Rauschcharakteristik ist, dass die Signalumwandlungsstufe, welche beispielsweise mit Hilfe eines Integrators realisiert werden kann, eine Tiefpass-Charakteristik aufweist. Dies bedeutet, dass höherfrequente Komponenten durch die Signalumwandlungsstufe teilweise unterdrückt werden. Bei klassischen Sigma-Delta-Wandlern verursacht diese Unterdrückung der höherfrequenten Anteile im Regelkreis einen Anstieg des Quantisierungsrauschens bei diesen höheren Frequenzen. Im niederfrequenten Bereich ist das Quantisierungsrauschen dagegen gering. Bei dem erfindungsgemäßen Pulsmodulator wird das am Ausgang der Signalumwandlungsstufe abgreifbare Regelsignal durch eine Multiplikation mit dem komplexen Mischsignal der Frequenz $w_0$ auf die Frequenz $w_0$ hochgemischt. Damit wird auch der Bereich niedrigen Quantisierungsrauschens von der Frequenz $\omega=0$ zur Mischfrequenz $\omega_0$ hin verlagert, obwohl die eingangsseitige Signalumwandlungsstufe weiterhin ein nicht hochgemischtes Signal verarbeitet. Auf diese Weise erhält man ein Pulssignal mit einem Rauschpegel, der in der Umgebung von wo gering ist.

Der erfindungsgemäße Pulsmodulator lässt sich kostengünstig implementieren, benötigt relativ wenig elektrische Leistung und lässt sich auf einfache Weise zusammen mit der digitalen Elektronik integrieren.

Es ist von Vorteil, wenn der Pulsmodulator einen Inphase-Signalpfad zur Verarbeitung des Realteils des Eingangssignals sowie einen Quadratur-Signalpfad zur Verarbeitung des Imaginärteils des Eingangssignals umfasst. Weiterhin ist es von Vorteil, wenn es sich bei dem Regelabweichungssignal, dem Regelsignal und dem Rückkopplungssignal jeweils um komplexe Signale handelt, die jeweils einen reellen Signalanteil sowie einen imaginären Signalanteil umfassen. Um zu erreichen, dass das reellwertige Pulssignal den Realteil oder Imaginärteil des um $\omega_0$ heraufgemischten Regelsignals phasenrichtig wiedergibt, werden die Subtrahiererstufe, die Signalumwandlungsstufe, die erste Multipliziererstufe und die Rückkopplungseinheit als komplexe Signalverarbeitungseinheiten ausgelegt, die jeweils einen Inphase- sowie einen Quadratur-Signalpfad aufweisen. Vom Ausgangssignal der ersten Multipliziererstufe wird aber lediglich der Realteil (oder aber der Imaginärteil) benötigt, um daraus mit Hilfe der Quantisierungsstufe das reellwertige Pulssignal abzuleiten. Die Quantisierungsstufe kann daher als reelle Verarbeitungsstufe ausgelegt sein. In der Rückkopplungseinheit wird das reellwertige Pulssignal dann allerdings wieder in ein komplexes Rückkopplungssignal übersetzt. Mit Hilfe dieser Auslegung des Pulsmodulators kann ein reellwertiges Pulssignal synthetisiert werden, das eine harmonische Schwingung der Frequenz $\omega_0$ mit geringem Phasen- und Amplitudenrauschen phasenrichtig wiedergibt.

Gemäß einer vorteilhaften Ausführungsform der Erfindung umfasst die Signalumwandlungsstufe eine Integratorstufe, die das Regelabweichungssignal aufsummiert und als Regelsignal ein integriertes Signal erzeugt. Durch Aufintegrieren des Regelabweichungssignals kann erreicht werden, dass das (komplexe) integrierte Signal ständig dem komplexen Eingangssignal nachgeführt wird. Da eine Integratorstufe eine Tiefpasscharakteristik aufweist, erhält man am Ausgang der Integratorstufe ein Regelsignal mit vermindertem Rauschpegel im Bereich um $\omega=0$. Wenn dieses Regelsignal dann durch die erste Multipliziererstufe heraufgemischt und anschließend quantisiert wird, erhält man ein Pulssignal mit der gewünschten Rauschcharakteristik.

Es ist von Vorteil, wenn die Integratorstufe einen ersten Integrator für den Inphase-Signalpfad und einen zweiten Integrator für den Quadratur-Signalpfad umfasst, wobei der erste Integrator den Realteil des Regelabweichungssignals aufsummiert, und wobei der zweite Integrator den Imaginärteil des Regelabweichungssignals aufsummiert. Eine komplexe Integratorstufe für das komplexe Regelabweichungssignal kann auf diese Weise mit Hilfe von zwei separaten Integratoren realisiert werden.

Es ist von Vorteil, wenn die Signalumwandlungsstufe eine Verstärkerstufe umfasst. Der Verstärkungsfaktor wird dabei so gewählt, dass der Quantisierer den richtigen Eingangssignalpegel erhält.

Gemäß einer weiteren vorteilhaften Ausführungsform der Erfindung umfasst die erste Multipliziererstufe einen ersten Multiplizierer für den Inphase-Signalpfad und einen zweiten Multiplizierer für den Quadratur-Signalpfad. Der erste Multiplizierer multipliziert den Realteil des Regelsignals mit dem Realteil des mit der Frequenz $\omega_0$ oszillierenden komplexen Mischsignals und erzeugt so ein erstes Ergebnissignal. Der zweite Multiplizierer multipliziert den Imaginärteil des Regelsignals mit dem Imaginärteil des mit der Frequenz $\omega_0$ oszillierenden komplexen Mischsignals und erzeugt so ein zweites Ergebnissignal. Gemäß einer weiteren vorteilhaften Ausführungsform umfasst der Pulsmodulator einen Addierer, welcher zur Bestimmung des Realteils des heraufgemischten Regelsignals das erste Ergebnissignal des ersten Multiplizierers und das zweite Ergebnissignal des zweiten Multiplizierers zu einem Summensignal addiert.

Wenn man annimmt, dass das komplexe Regelsignal die Form $R+j\cdot I$ besitzt, und man das komplexe Mischsignal beispielsweise in der Form $e^{-j\omega_0 t}$ darstellt, dann ergibt sich das erste Ergebnissignal des ersten Multiplizierers zu $R\cdot\cos(\omega_0 t)$. Das zweite Ergebnissignal des zweiten Multiplizierers nimmt die Form $I\cdot\sin(\omega_0 t)$ an, und als Summensignal liefert der Addierer das Signal $R\cdot\cos(\omega_0 t)+I\cdot\sin(\omega_0 t)$. Dieses Signal entspricht aber genau dem Realteil von $(R+j\cdot I)\cdot e^{-j\omega_0 t}$. Mittels des ersten Multiplizierers, des zweiten Multiplizierers und des Addierers kann so der Realteil der komplexen Multiplikation von Regelsignal und Mischsignal ermittelt werden.

Gemäß einer vorteilhaften Ausführungsform der Erfindung wird das vom Addierer gelieferte Summensignal dann von der Quantisierungsstufe quantisiert, um so das reellwertige Pulssignal zu erzeugen.

Dabei ist es von Vorteil, wenn zum Eingangssignal der Quantisierungsstufe ein Rauschpegel addiert wird. Der Pulsmodulator wird mit einer Abtastfrequenz $\omega_A$ getaktet, die deutlich höher sein muss als die Mischfrequenz $w_0$. Bei bestimmten Verhältnissen von $\omega_0$ zu $\omega_A$ bilden sich im Pulsmodulator Kippschwingungen, die als zusätzliche Peaks im Frequenzspektrum des Pulssignals erkennbar sind. Indem man zum Eingangssignal des Quantisierers ein Rauschsignal addiert, wird das Ergebnis der Quantisierung statistisch gerundet. Mit Hilfe dieses Tricks kann die Ausbildung von Kippschwingungen verhindert werden.

Die Quantisierungsstufe führt vorzugsweise eine binäre Quantisierung oder eine ternäre Quantisierung ihres jeweiligen Eingangssignals durch. Bei der binären Quantisierung kann das Pulssignal lediglich die Werte 0 und 1 annehmen. Man erhält daher ein Pulssignal, das lediglich positive Spannungspulse enthält. Ein ternär quantisiertes Pulssignal kann die Werte -1, 0, 1 annehmen. Ein derartiges Pulssignal umfasst daher sowohl positive als auch negative Spannungspulse. Eine ternäre Quantisierung wird daher immer dann durchgeführt, wenn ein Pulssignal mit sowohl positiven als auch negativen Pulsen benötigt wird.

Vorzugsweise umfasst die Rückkopplungseinheit eine zweite Multipliziererstufe, die das Pulssignal mit einem mit der Frequenz $\omega_0$ oszillierenden konjugiert komplexen Mischsignal multipliziert und so das um $\omega_0$ heruntergemischte Rückkopplungssignal für den Subtrahierer erzeugt. Das Pulssignal wurde durch Quantisierung des Realteils des heraufgemischten Regelsignals erzeugt und besitzt daher bei der Frequenz $\omega_0$ seine dominierende Frequenzkomponente. Bevor das Pulssignal als Rückkopplungssignal verwendet werden kann, muss es daher wieder ins Basisband heruntergemischt werden. Zu diesem Zweck wird das Pulssignal mit einem konjugiert komplexen Mischsignal der Frequenz $\omega_0$ multipliziert, um so ein heruntergemischtes komplexes Rückkopplungssignal zu erhalten.

Vorzugsweise umfasst die zweite Multipliziererstufe einen dritten Multiplizierer zur Erzeugung des Realteils des Rückkopplungssignals und einen vierten Multiplizierer zur Erzeugung des Imaginärteils des Rückkopplungssignals. Der dritte Multiplizierer multipliziert das Pulssignal mit dem Realteil des mit der Frequenz $\omega_0$ oszillierenden konjugiert komplexen Mischsignals, und der vierte Multiplizierer multipliziert das Pulssignal mit dem Imaginärteil des konjugiert komplexen Mischsignals der Frequenz $\omega_0$. Um die bei der Frequenz $\omega_0$ befindliche Frequenzkomponente des Pulssignals in die richtige Richtung zu verschieben, muss die Multiplikation des Pulssignals mit dem Mischsignal im Komplexen durchgeführt werden. Bei dem Pulssignal y(t) handelt es sich um ein reelles Signal, während das konjugiert komplexe Mischsignal in der Form $e^{+j\omega_0 t}$ dargestellt werden kann. Die komplexe Multiplikation liefert daher ein komplexes Rückkopplungssignal mit dem Realteil $y(t)\cdot\cos(\omega_0 t)$ und dem Imaginärteil $y(t)\cdot\sin(\omega_0 t)$.

Vorzugsweise wird der Pulsmodulator mit einer Abtastfrequenz $\omega_A$ betrieben, welche 2 bis 1000 mal höher ist als die Mischfrequenz $\omega_0$. Dies ist notwendig, um hinsichtlich der heraufgemischten Signale die Nyquist-Bedingung zu erfüllen.

Gemäß einer weiteren vorteilhaften Ausführungsform ist der Pulsmodulator mit Hilfe eines digitalen Signalprozessors (DSP) implementiert. Sämtliche für den Betrieb des Pulsmodulators erforderlichen Operationen lassen sich mit Hilfe von Signalverarbeitungsroutinen programmieren.

Die erfindungsgemäße Ansteuerschaltung für einen mikromechanischen Resonator umfasst mindestens einen Pulsmodulator der oben beschriebenen Art. Vorzugsweise wird das von dem mindestens einen Pulsmodulator erzeugte Pulssignal zur elektrostatischen Schwingungsanregung des Resonators verwendet. Das erzeugte Pulssignal kann direkt mit den Anregungselektroden des Resonators verbunden werden. Dabei ist es von Vorteil, wenn die Mischfrequenz $\omega_0$ des Pulsmodulators einer Resonanzfrequenz des Resonators entspricht, denn dann ist eine effektive Anregung des Schwingers gewährleistet.

Ein erfindungsgemäßer Frequenzgenerator zur Synthese eines Pulssignals mit vorgegebener Frequenz und Phase umfasst mindestens einen Pulsmodulator der oben beschriebenen Art. Mit dem erfindungsgemäßen Pulsmodulator kann zu einer vorgegebenen Frequenz und Phase ein entsprechendes Pulssignal y(t) erzeugt werden. Dabei kann die Phasenlage des erzeugten Pulssignals über das Verhältnis von Realteil und Imaginärteil des Eingangssignals x(t) sehr genau vorgegeben werden. Das erzeugte Pulssignal weist in der Umgebung von $\omega_0$ einen geringen Rauschpegel auf.

Gemäß einer weiteren vorteilhaften Ausführungsform ist dem Pulsmodulator ein Bandpassfilter, vorzugsweise ein Quarz- oder Keramikfilter, nachgeschaltet. Mit diesem nachgeschalteten Bandpass lassen sich die weiter von $\omega_0$ entfernten Frequenzanteile wegfiltern, in denen der Rauschpegel hoch ist.

Die Erfindung und weitere vorteilhafte Einzelheiten werden nachfolgend unter Bezug auf die Zeichnungen in beispielhaften Ausführungsformen näher erläutert. Es zeigen:

**Fig. 1**     ein komplexes Blockschaltbild des erfindungsgemäßen Pulsmodulators;

**Fig. 2**     ein Blockdiagramm des Pulsmodulators, in dem der Inphase- und der Quadraturpfad separat eingezeichnet sind;

**Fig. 3**    ein ternär quantisiertes Pulssignal y(t);

**Fig. 4**    ein Frequenzspektrum des am Ausgang des Quantisierers erhaltenen Pulssignals y(t);

**Fig. 5**    das Frequenzspektrum von Fig. 4 nach einer Filterung durch einen mikromechanischen Schwinger;

**Fig. 6**    ein Frequenzspektrum eines Pulssignals y(t), das für ein Verhältnis von Mischfrequenz zu Abtastfrequenz von $\omega_0/\omega_A = 0{,}25$ aufgezeichnet wurde;

**Fig. 7**    einen Pulsmodulator mit statistischer Rundung;

**Fig. 8**    das Frequenzspektrum von Fig. 6 bei Durchführung einer statistischen Rundung; und

**Fig. 9**    ein Blockdiagramm eines zweidimensionalen Pulsmodulators.

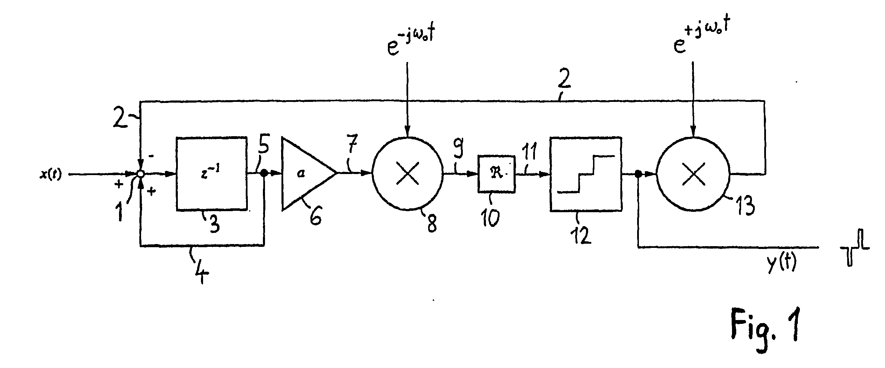

Fig. 1 zeigt ein Blockschaltbild des erfindungsgemäßen Pulsmodulators in komplexer Darstellung. Das komplexe Eingangssignal x(t) umfasst einen Realteil sowie einen Imaginärteil, welche beide als digitale Werte repräsentiert werden. Im Addiererknoten 1 wird von dem komplexen Eingangssignal x(t) das komplexe Rückkopplungssignal 2 subtrahiert, wobei die Differenz dieser beiden komplexen Signale die Regelabweichung darstellt. Außerdem wird im Addiererknoten 1 der (ebenfalls komplexe) Inhalt des Verzögerungsglieds 3 zu dieser Differenz dazu addiert. Der Inhalt des Verzögerungsglieds 3 wird über die Signalleitung 4 zum Addiererknoten 1 geführt. Das Verzögerungsglied 3 bildet mit der Signalleitung 4 zusammen eine komplexe Integratorstufe, welche die komplexe Regelabweichung, also die Differenz von Eingangssignal und Rückkopplungssignal aufintegriert. Das aufintegrierte Signal 5 wird in der Verstärkerstufe 6 entsprechend dem Faktor "a" verstärkt, und das verstärkte Signal 7 wird der ersten Multipliziererstufe 8 zugeführt. Dort wird das verstärkte Signal 7 mit dem komplexen Mischsignal $e^{-j\omega_0 t}$ multipliziert, um so das auf die Frequenz $\omega_0$ heraufgemischte Signal 9 zu erhalten. Der Block 10 ermittelt den Realteil des komplexen heraufgemischten Signals 9, und der so erhaltene Realteil 11 des heraufgemischten Signals wird dem Quantisierer 12 zur Verfügung gestellt.

Bei der in Fig. 1 gezeigten Ausführungsform ist der Quantisierer 12 als ternärer Quantisierer ausgeführt, welcher das jeweilige Eingangssignal mit Hilfe von Komparatoren in die drei möglichen Werte -1, 0, +1 eines Pulssignals umsetzt. Das auf diese Weise erzeugte quantisierte Pulssignal y(t) kann am Ausgang des Quantisierers 12 abgegriffen werden. Zur Erzeugung des komplexen Rückkopplungssignals 2 wird das reellwertige Pulssignal y(t) in der zweiten Multipliziererstufe 13 mit dem konjugiert komplexen Mischsignal $e^{+j\omega_0 t}$ multipliziert. Das auf diese Weise durch Multiplikation einer reellen und einer komplexen Zahl erhaltene komplexe Rückkopplungssignal 2 wird dem Addiererknoten 1 am Eingang der Schaltung zugeführt.

Die in Fig. 1 dargestellte Abfolge von funktionalen Einheiten lässt sich mittels eines digitalen Signalprozessors (DSP) oder aber mittels einer speziell hierfür vorgesehenen Hardware implementieren. Die digitale Signalverarbeitung muss dabei mit einer Abtastfrequenz $\omega_A$ durchgeführt werden, welche deutlich höher ist als die Frequenz $\omega_0$ des komplexen Mischsignals. Beispielsweise kann als Abtastrate $\omega_A$ das 2- bis 1000-fache der Mischfrequenz $\omega_0$ verwendet werden.

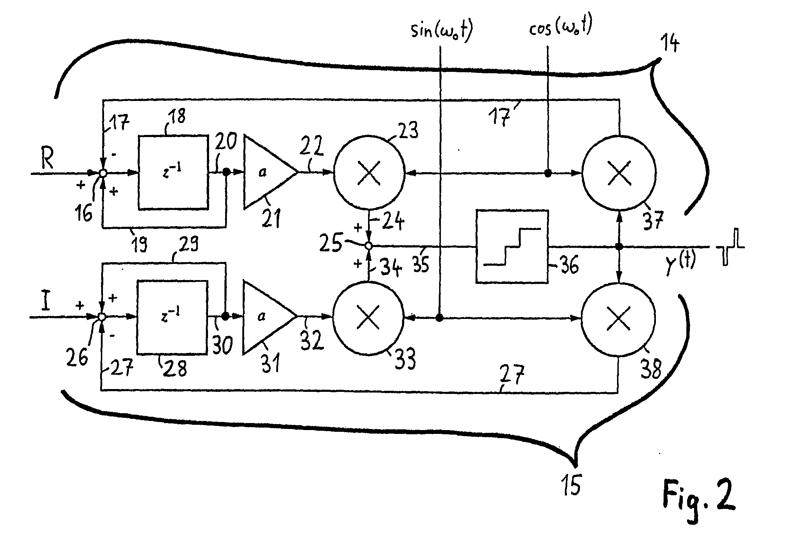

In Fig. 2 ist der Pulsmodulator von Fig. 1 noch einmal dargestellt, wobei hier der Inphase-Signalpfad und der Quadratur-Signalpfad separat eingezeichnet sind. Die obere Hälfte von Fig. 2 stellt den Inphase-Signalpfad 14 dar, der den Realteil R des Eingangssignals x(t) verarbeitet. Die untere Hälfte von Fig. 2 zeigt den Quadratur-Signalpfad 15 zur Verarbeitung des Imaginärteils I des Eingangssignals. Im Addiererknoten 16 des Inphase-Signalpfads wird der Realteil der Regelabweichung als Differenz des Realteils R des Eingangssignals und des Realteils 17 des Rückkopplungssignals ermittelt. Zu dieser Regelabweichung wird der bisher im Verzögerungsglied 18 gespeicherte Integratorwert addiert, der über die Signalleitung 19 dem Addiererknoten 16 zugeführt wird. Das Verzögerungsglied 18 bildet zusammen mit der Signalleitung 19 einen Integrator mit der Übertragungsfunktion $H(z) = \dfrac{1}{1 - z^{-1}}$. Durch Addition des Realteils der Regelabweichung zu dem bisherigen Integratorwert wird ein neuer Integratorwert erhalten, der wiederum im Verzögerungsglied 18 gespeichert wird. Das aufintegrierte Signal 20 des Inphase-Signalpfads wird durch den Verstärker 21 mit dem Faktor "a" skaliert, und gelangt, als verstärktes Signal 22, zum ersten Multiplizierer 23. Der erste Multiplizierer 23 multipliziert das reellwertige verstärkte Signal 22 mit dem reellen Signal $\cos(\omega_0 t)$, also mit dem Realteil von $e^{-j\omega_0 t}$. Der erste Multiplizierer 23 ermittelt das Produkt $R \cdot \cos(\omega_0 t)$, welches als Signal 24 dem Addierer 25 zugeführt wird.

Der Quadratur-Signalpfad 15 des Pulsmodulators umfasst einen Addiererknoten 26, in dem die Differenz des Imaginärteils I des Eingangssignals und des Imaginärteils 27 des Rückkopplungssignals berechnet wird. Diese Differenz, die dem Imaginärteil der Regelabweichung entspricht, wird zu dem bisherigen Inhalt des Verzögerungsglieds 28 addiert, der dem Addiererknoten 26 über die Signalleitung 29 zugeführt wird. Der als Summe des bisherigen Werts und des Imaginärteils der Regelabweichung erhaltene neue Wert wird in das Verzögerungsglied 28 eingeschrieben. Das Verzögerungsglied 28 bildet zusammen mit der Signalsleitung 29 einen Integrator mit der Übertragungsfunktion

$$H(z) = \frac{1}{1 - z^{-1}}$$

. Am Ausgang dieses Integrators erhält man das aufintegrierte Signal 30 des Quadratur-Signalpfads, welches durch den Verstärker 31 mit dem Faktor "a" skaliert wird. Das so erhaltene verstärkte Signal 32 des Quadratur-Signalpfads wird anschließend im zweiten Multiplizierer 33 mit dem Signal $\sin(\omega_0 t)$ multipliziert. Das so erhaltene Produkt I. $\sin(\omega_0 t)$ wird, als Signal 34, dem Addierer 25 zugeführt. Der Addierer 25 addiert die Signale $R \cdot \cos(\omega_0 t)$ und I. $\sin(\omega_0 t)$ und erzeugt an seinem Ausgang das Signal $R \cdot \cos(\omega_0 t) + I \cdot \sin(\omega_0 t)$ als Signal 35. Dieses Signal 35 entspricht aber genau dem Realteil des heraufgemischten Signals, denn die komplexe Multiplikation von x(t) und $e^{-j\omega_0 t}$ liefert:

$$x(t) \cdot e^{-j\omega_0 t} =$$
$$= (R + j \cdot I) \cdot (\cos(\omega_0 t) - j \cdot \sin(\omega_0 t)) =$$
$$= [R \cdot \cos(\omega_0 t) + I \cdot \sin(\omega_0 t)] + j \cdot [I \cdot \cos(\omega_0 t) - R \cdot \sin(\omega_0 t)]$$

und der Realteil dieses Signals ergibt sich zu $R \cdot \cos(\omega_0 t) + I \cdot \sin(\omega_0 t)$. Daher stellt das Signal 35 den Realteil des komplexwertigen heraufgemischten Signals dar und entspricht insofern dem in Fig. 1 dargestellten Signal 11.

Das digitale reellwertige Signal 35 wird dem Quantisierer 36 zugeführt, der dieses Eingangssignal in das quantisierte Pulssignal y(t) umsetzt. Der im Beispiel von Fig. 1 und Fig. 2 gezeigte dreistufige (ternäre) Quantisierer quantisiert das Eingangssignal entsprechend $y(t) \in \{-1; 0; +1\}$. Hierzu weist der Quantisierer 36 Komparatoren auf, die den Signalpegel des Signals 35 ständig mit vorgegebenen Schwellwerten vergleichen. Entsprechend dem Ergebnis dieser Vergleiche wird dem Ausgangssignal y(t) jeweils einer der Werte -1; 0; +1 als aktueller Signalwert zugewiesen. Anstelle der dreistufigen (ternären) Quantisierung können in Abhängigkeit vom Einsatzzweck beliebige andere Quantisierungen zum Einsatz kommen, z. B. zweistufige (binäre) oder mehrstufige Quantisierungen.

Aus dem quantisierten Pulssignal y(t) werden der Realteil 17 sowie der Imaginärteil 27 des komplexwertigen Rückkopplungssignals abgeleitet. Dazu wird das Pulssignal y(t) mit dem konjugiert komplexen Mischsignal $e^{+j\omega_0 t}$ multipliziert:

$$y(t) \cdot e^{j\omega_0 t} = y(t) \cdot \cos(\omega_0 t) + j \cdot y(t) \cdot \sin(\omega_0 t)$$

Der Realteil $y(t) \cdot \cos(\omega_0 t)$ des komplexwertigen Rückkopplungssignals wird vom dritten Multiplizierer 37 erzeugt, der das Pulssignal y(t) mit dem $\cos(\omega_0 t)$ multipliziert. Am Ausgang des dritten Multiplizierers 37 erhält man daher den Realteil 17 des Rückkopplungssignals, der zum Addiererknoten 16 zurückgeführt wird. Um den Imaginärteil $y(t) \cdot \sin(\omega_0 t)$ des komplexen Rückkopplungssignals zu erzeugen, wird im vierten Multiplizierer 38 das Pulssignal y(t) mit $\sin(\omega_0 t)$ multipliziert. Am Ausgang des vierten Multiplizierers 38 erhält man den Imaginärteil 27 des Rückkopplungssignals, der zum Addiererknoten 26 zurückgeführt wird.

In den Ausführungsbeispielen der Fig. 1 und 2 sind eingangsseitig Integratoren vorgesehen, die die Regelabweichung zwischen Eingangssignal und Rückkopplungssignal aufsummieren und so ein aufintegriertes Signal erzeugen.

Die Übertragungsfunktion H(z) eines Integrators kann geschrieben werden als $H(z) = \frac{1}{1 - z^{-1}}$. Anstelle der Integratoren können eingangsseitig auch andere Signalumformungsstufen mit anderen Übertragungsfunktionen H(z) eingesetzt werden. Beispielsweise könnten Übertragungsfunktionen H(z) von höherer Ordnung verwendet werden, wobei jedoch

$$\lim_{z \to 1} H(z) = \infty$$

gelten sollte. Die Übertragungsfunktion H(z) sollte also für den Fall, dass sich die Frequenz $\omega$ dem Wert Null annähert $(z \to 1)$, gegen Unendlich gehen. Die zusätzlichen freien Parameter von H(z) können dazu verwendet werden, bestimmte Eigenschaften des Modulators (z. B. das Signal-Rausch-Verhältnis) oder des Gesamtsystems zu optimieren.

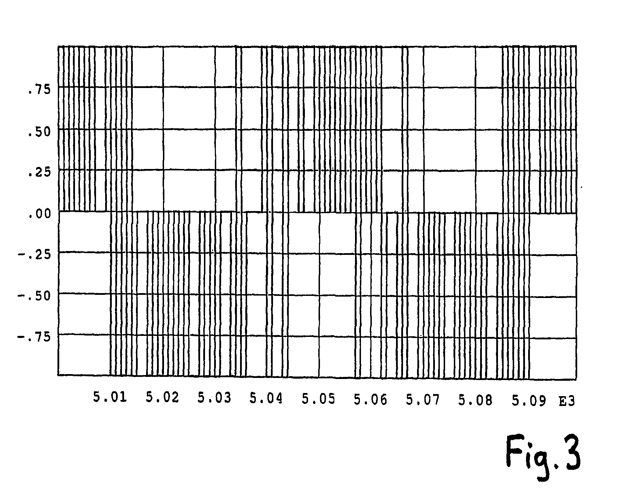

In Fig. 3 ist der zeitliche Verlauf des am Ausgang des Quantisierers abgreifbaren Pulssignals y(t) für den Fall einer ternären Quantisierung mit y(t) $\in$ {-1;0;+1} dargestellt, welcher mit Hilfe einer Computersimulation ermittelt wurde. Dabei wurde der Realteil R des komplexen Eingangssignals auf 0,3 gesetzt, während der Imaginärteil I des Eingangssignals gleich Null gesetzt wurde. Das Eingangssignal x(t) ist daher konstant und variiert nicht als Funktion der Zeit. Die Abtastfrequenz $\omega_A$ ist fünfmal so hoch wie die Mischfrequenz, $\omega_0/\omega_A=0,2$. Auf der Abszisse sind die Takte der Abtastfrequenz $\omega_A$ dargestellt, die von 5000 bis 5100 durchnummeriert sind. Während jedes Takts nimmt das Pulssignal y(t) einen der drei möglichen Werte -1; 0; +1 an. Der jeweilige Wert von y(t) während eines bestimmten Takts der Abtastfrequenz ist in Richtung der Ordinate aufgetragen.

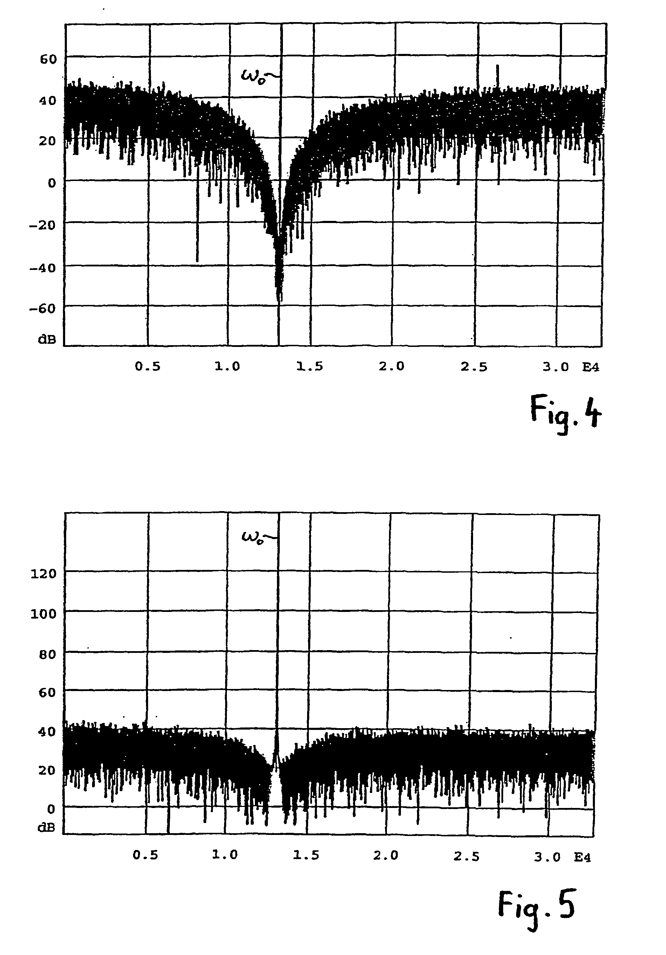

Wenn man eine Spektralanalyse (FFT) des in Fig. 3 dargestellten Pulssignals durchführt, erhält man das in Fig. 4 gezeigte Spektrum. Auf der Abszisse ist die Frequenz der jeweiligen spektralen Komponenten in willkürlichen FFT-Einheiten angegeben, während in Richtung der Ordinate die Signalintensität in dB aufgetragen ist. Bei der Frequenz $w_0$ ist ein Peak der spektralen Verteilung zu erkennen. Außerdem lässt sich feststellen, dass der Rauschpegel in der Umgebung der Frequenz $w_0$ deutlich niedriger ist als im restlichen Teil des Spektrums. Bei einem klassischen Sigma-Delta-Modulator wäre der Rauschpegel dagegen bei niedrigen Frequenzen deutlich vermindert, also in der Nähe der Frequenz $\omega=0$. Bei dem erfindungsgemäßen Pulsmodulator wird das aufintegrierte und verstärkte Signal mittels einer komplexen Multiplikation auf die Mischfrequenz $\omega_0$ heraufgemischt. Dadurch wird auch der Spektralbereich, in dem das Rauschen verringert ist, zur Mischfrequenz wo hin verlagert, und deshalb erhält man die in Fig. 4 gezeigte Rauschcharakteristik.

Der erfindungsgemäße Pulsmodulator kann zur digitalen Synthese eines Pulssignals verwendet werden, wobei die spektrale Hauptkomponente des Impulssignals durch die Mischfrequenz $w_0$ vorgegeben werden kann. Über das Verhältnis von Realteil zu Imaginärteil des Eingangssignals kann die Phasenlage des erzeugten Pulssignals exakt eingestellt werden, und man erhält ein phasenstabiles Pulssignal. Bei Verwendung des erfindungsgemäßen Pulsmodulators zur Frequenzsynthese sollte das Pulssignal y(t) mittels eines elektrischen Bandfilters gefiltert werden, dessen Durchlassbereich um die Frequenz $w_0$ zentriert ist. Mit Hilfe dieses Bandpasses, der beispielsweise als Quarz- bzw. Keramikfilter ausgeführt sein kann, können weiter von $w_0$ entfernte Spektralbereiche unterdrückt werden, in denen der Rauschpegel unerwünscht hoch ist. Mittels eines derartigen Bandpasses lässt sich das Signal-Rausch-Verhältnis signifikant verbessern.

Der erfindungsgemäße Pulsmodulator eignet sich unter anderem dazu, elektromechanische Schwinger zu harmonischen Schwingungen anzuregen. Insbesondere mittels eines ternär quantisierten Pulssignals, welches an die Anregungselektroden eines mikromechanischen Resonators angelegt wird, können die für die Schwingungsanregung erforderlichen elektrostatischen Kräfte erzeugt werden. Die Frequenz $\omega_0$ des Pulssignals y(t) wird dabei bevorzugterweise gleich der Resonanzfrequenz des mikromechanischen Schwingers gewählt. Wenn das in Fig. 3 und Fig. 4 dargestellte Pulssignal zur harmonischen Anregung eines Schwingers hoher Güte (beispielsweise der Güte $10^4$) verwendet wird, dessen Resonanzfrequenz der Anregungsfrequenz $\omega_0$ entspricht, dann wird der überwiegende Teil des Quantisierungsrauschens vom Schwinger selbst weggefiltert. Insbesondere das Quantisierungsrauschen in weiter von der Resonanzfrequenz $w_0$ entfernten Spektralbereichen wird durch den Schwinger selbst unterdrückt. Das so erhaltene gefilterte Spektrum ist in Fig. 5 gezeigt.

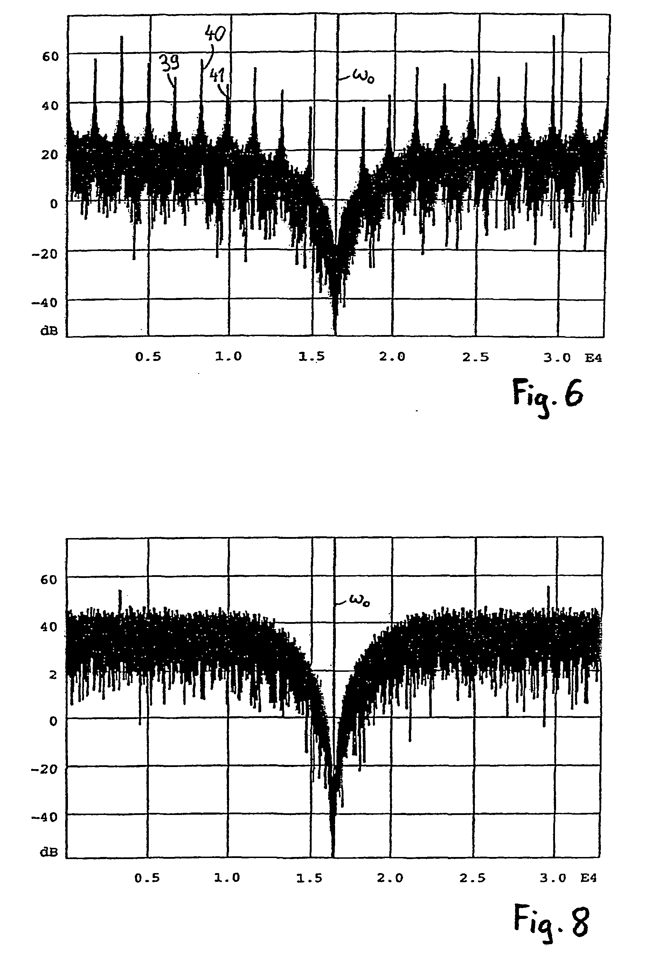

Es gibt bestimmte Verhältnisse der Frequenzen $\omega_0/\omega_A$, bei denen sich das rauschartige Quantisierungsprodukt in y(t) in eine Reihe von mehr oder weniger periodischen Funktionen wandelt. Als Beispiel hierzu ist in Fig. 6 ein Frequenzspektrum gezeigt, welches für das Verhältnis $\omega_0/\omega_A$ = 0,25 erhalten wurde. Neben dem Peak bei der Frequenz $\omega_0$ sind eine Reihe von Spektrallinien 39, 40, 41, etc. erkennbar. Die Ursache für das Entstehen dieser Spektrallinien ist, dass der Quantisierer ein stark nicht-lineares Glied des Regelkreises ist, denn dadurch werden im Regelkreis bei bestimmten Frequenzverhältnissen Kippschwingungen angeregt. Dieses Verhalten des Regelkreises ist von klassischen Delta-Sigma-Wandlern her bekannt.

Um das Entstehen der Kippschwingungen zu verhindern, kann man die mittlere Linearität des Quantisierers verbessern, indem ein Rauschsignal, zum Eingangssignal des Quantisierers addiert wird. Vorzugsweise wird hierzu ein spektral gleichverteiltes Rauschsignal verwendet. Fig. 7 zeigt das Blockschaltbild eines entsprechend modifizierten Pulsmodulators. Gegenüber dem in Fig. 2 gezeigten Blockschaltbild umfasst der in Fig. 7 gezeigte Pulsmodulator zusätzlich einen Rauschgenerator 42, der ein Rauschsignal 43 erzeugt. Außerdem sind die in Fig. 2 gezeigten Integratoren verallgemeinert als Signalumwandlungsstufen 44, 45 mit der Überfunktion H(z) dargestellt. Ansonsten stimmen die in Fig. 7 gezeigten Baugruppen mit den Elementen des Blockschaltbilds von Fig. 2 überein. Das Rauschsignal 43 wird dem Addierer 25 zugeführt und dort zu den Signalen 24 und 34 addiert. Das Signal 35 am Eingang des Quantisierers 36 ist deshalb von einem Rauschsignal überlagert, und dies führt letztlich zu einer statistischen Rundung bei der Quantisierung. In Fig. 8 ist das Frequenzspektrum eines Pulssignals y(t) gezeigt, das mit Hilfe eines gemäß Fig. 7 modifizierten Pulsmodulators erzeugt wurde. Obwohl das Frequenzverhältnis $\omega_0/\omega_A$ wieder gleich 0,25 ist, kommt es nicht zur Ausbildung von Kippschwingungen.

Der erfindungsgemäße Pulsmodulator lässt sich insbesondere zur elektrostatischen Anregung von mikromechanischen Schwingern verwenden. Hierzu kann beispielsweise ein ternär quantisiertes Pulssignal der in Fig. 3 gezeigten Art mit den Anregungselektroden eines mikromechanischen Resonators verbunden werden. Das in Fig. 3 gezeigte Pulssignal repräsentiert ein sinusoidales Signal der Frequenz $\omega_0$. Mit einem derartigen Pulssignal kann daher ein mikromechanischer Resonator zu harmonischen Schwingungen der Frequenz $\omega_0$ angeregt werden, und zwar insbesondere dann, wenn die Frequenz $\omega_0$ des Pulssignals zumindest ungefähr der Resonanzfrequenz des Schwingers entspricht.

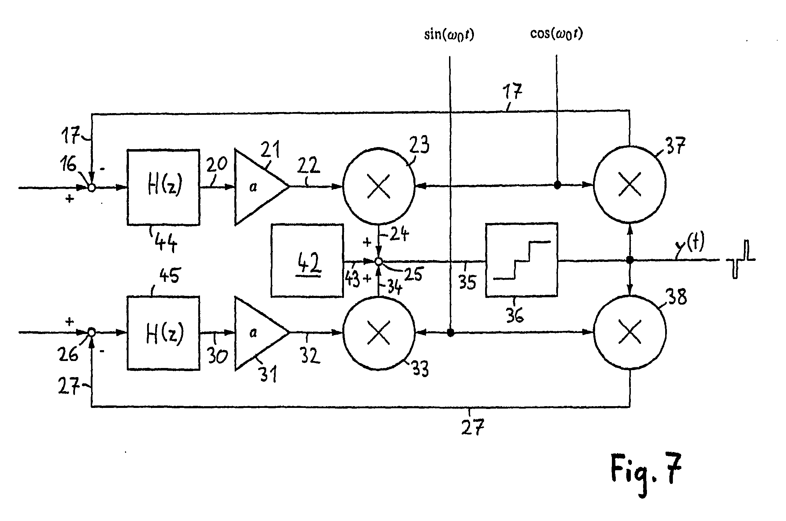

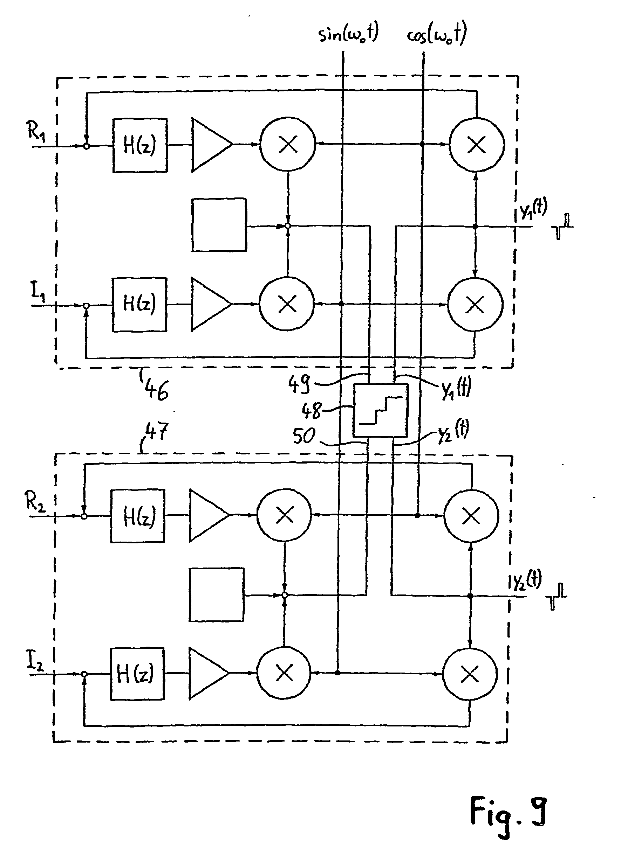

Für die Anwendung in Drehratensensoren bzw. Coriolis-Kreiseln werden Resonatoren verwendet, die in zwei zueinander senkrechten Richtungen $y_1$ und $y_2$ schwingen können. Zur elektrostatischen Anregung eines Resonators mit zwei Freiheitsgraden kann der in Fig. 9 gezeigte zweidimensionale Pulsmodulator verwendet werden. Der zweidimensionale Pulsmodulator umfasst einen ersten Pulsmodulator 46, der aus dem komplexen Eingangssignal $R_1$, $I_1$ das Pulssignal $y_1(t)$ erzeugt, das zur Anregung des Resonators in $y_1$-Richtung dient. Mit dem zweiten Pulsmodulator 47 wird aus dem komplexen Eingangssignal $R_2$, $I_2$ das Pulssignal $y_2(t)$ erzeugt, mit dem der Schwinger zu Schwingungen in $y_2$-Richtung angeregt wird. Sowohl beim ersten Pulsmodulator 46 als auch beim zweiten Pulsmodulator 47 handelt es sich um einen Pulsmodulator mit statistischer Rundung gemäß Fig. 7. Eine Darstellung des Aufbaus und der Funktionsweise des ersten und des zweiten Pulsmodulators 46, 47 kann deshalb der Figurenbeschreibung zu den Fig. 2 und 7 entnommen werden. Allerdings weist der in Fig. 9 gezeigte zweidimensionale Pulsmodulator einen für beide Kanäle gemeinsamen 2D-Quantisierer 48 auf, der das Signal 49 des ersten Pulsmodulators 46 in das quantisierte Pulssignal $y_1(t)$ umwandelt, und der das Signal 50 des zweiten Pulsmodulators 47 in das quantisierte Pulssignal $y_2(t)$ transformiert. Der Einsatz eines für beide Kanäle gemeinsamen 2D-Quantisierers 48 gestattet es, bei der Quantisierung der Signale 49, 50 Zusatzbedingungen zu berücksichtigen, die für den Betrieb des mikromechanischen Sensors von Vorteil sind. Eine derartige Zusatzbedingung ist beispielsweise, dass jeweils nur einer der Kanäle von Null verschiedene Impulse liefern darf. Eine andere denkbare Zusatzbedingung ist, dass sich zu einem gegebenen Zeitpunkt jeweils nur eines der Ausgangssignale $y_1(t)$, $y_2(t)$ ändern darf. Derartige Zusatzbedingungen können dann sinnvoll sein, wenn die auf die Elektroden eines Doppelresonators aufgebrachten Verschiebungsströme summarisch gemessen werden, um auf die Auslenkung des Schwingers rückschließen zu können. Mit Hilfe der Zusatzbedingungen wird eine eindeutige Zuordnung eines Verschiebungsstroms zu einer bestimmten Elektrode ermöglicht. Dadurch lässt sich eine Signaltrennung der von der $y_1$-Auslenkung und der $y_2$-Auslenkung des Schwingers verursachten Signale durchführen.

**Patentansprüche**

1. Pulsmodulator zur Umwandlung eines komplexen Eingangssignals (x(t)) in ein Pulssignal (y(t)), **gekennzeichnet durch**

   - eine Subtrahiererstufe (1), die aus der Differenz des komplexen Eingangssignals (x(t)) und eines Rückkopplungssignals (2) ein Regelabweichungssignal erzeugt;
   - eine Signalumwandlungsstufe, die das Regelabweichungssignal in ein Regelsignal (7) umwandelt;
   - eine erste Multipliziererstufe (8), die das Regelsignal (7) mit einem mit der Frequenz $\omega_0$ oszillierenden komplexen Mischsignal multipliziert und so mindestens einen von Realteil (11) und Imaginärteil eines um $\omega_0$ heraufgemischten Regelsignals erzeugt;
   - eine Quantisierungsstufe (12), die mindestens einen von Realteil und Imaginärteil des um $\omega_0$ heraufgemischten Regelsignals quantisiert und so das Pulssignal (y(t)) erzeugt;
   - eine Rückkopplungseinheit, welche ausgehend von dem Pulssignal (y(t)) das Rückkopplungssignal (2) für die Subtrahiererstufe erzeugt.

2. Pulsmodulator nach Anspruch 1, **dadurch gekennzeichnet, dass** der Pulsmodulator einen Inphase-Signalpfad zur Verarbeitung des Realteils des Eingangssignals sowie einen Quadratur-Signalpfad zur Verarbeitung des Imaginärteils des Eingangssignals umfasst.

3. Pulsmodulator nach Anspruch 1 oder 2, **dadurch gekennzeichnet, dass** es sich bei dem Regelabweichungssignal, dem Regelsignal und dem Rückkopplungssignal jeweils um komplexe Signale handelt, die jeweils einen reellen Signalanteil sowie einen imaginären Signalanteil umfassen.

4. Pulsmodulator nach einem der vorstehenden Ansprüche, **dadurch gekennzeichnet, dass** die Signalumwandlungsstufe eine Integratorstufe umfasst, die das Regelabweichungssignal aufsummiert und als Regelsignal ein integriertes Signal erzeugt.

5. Pulsmodulator nach Anspruch 4, **dadurch gekennzeichnet, dass** die Integratorstufe einen ersten Integrator für den Inphase-Signalpfad (14) und einen zweiten Integrator für den Quadratur-Signalpfad (15) umfasst, wobei der erste Integrator den Realteil des Regelabweichungssignals aufsummiert, und wobei der zweite Integrator den Imaginärteil des Regelabweichungssignals aufsummiert.

**6.** Pulsmodulator nach einem der vorstehenden Ansprüche, **dadurch gekennzeichnet, dass** die Signalumwandlungsstufe eine Verstärkerstufe (6) umfasst.

**7.** Pulsmodulator nach einem der vorstehenden Ansprüche, **dadurch gekennzeichnet, dass** die erste Multipliziererstufe einen ersten Multiplizierer (23) für den Inphase-Signalpfad und einen zweiten Multiplizierer (33) für den Quadratur-Signalpfad umfasst, wobei der erste Multiplizierer den Realteil (22) des Regelsignals mit dem Realteil des mit der Frequenz $w_0$ oszillierenden komplexen Mischsignals multipliziert und so ein erstes Ergebnissignal (24) erzeugt, und wobei der zweite Multiplizierer (33) den Imaginärteil (32) des Regelsignals mit dem Imaginärteil des mit der Frequenz $w_0$ oszillierenden komplexen Mischsignals multipliziert und so ein zweites Ergebnissignal (34) erzeugt.

**8.** Pulsmodulator nach Anspruch 7, **gekennzeichnet durch** einen Addierer (25), welcher zur Bestimmung des Realteils des heraufgemischten Regelsignals das erste Ergebnissignal (24) des ersten Multiplizierers und das zweite Ergebnissignal (34) des zweiten Multiplizierers zu einem Summensignal (35) addiert.

**9.** Pulsmodulator nach Anspruch 8, **dadurch gekennzeichnet, dass** die Quantisierungsstufe das vom Addierer gelieferte Summensignal quantisiert.

**10.** Pulsmodulator nach einem der vorstehenden Ansprüche, **dadurch gekennzeichnet, dass** zum Eingangssignal der Quantisierungsstufe ein Rauschpegel addiert wird.

**11.** Pulsmodulator nach einem der vorstehenden Ansprüche, **dadurch gekennzeichnet, dass** die Quantisierungsstufe eine binäre Quantisierung oder eine ternäre Quantisierung ihres jeweiligen Eingangssignals durchführt.

**12.** Pulsmodulator nach einem der vorstehenden Ansprüche, **dadurch gekennzeichnet, dass** die Rückkopplungseinheit eine zweite Multipliziererstufe (13) umfasst, die das Pulssignal mit einem mit der Frequenz $w_0$ oszillierenden konjugiert komplexen Mischsignal multipliziert und so das um $w_0$ heruntergemischte Rückkopplungssignal (2) für den Subtrahierer erzeugt.

**13.** Pulsmodulator nach Anspruch 12, **dadurch gekennzeichnet, dass** die zweite Multipliziererstufe einen dritten Multiplizierer (37) zur Erzeugung des Realteils (17) des Rückkopplungssignals und einen vierten Multiplizierer (38) zur Erzeugung des Imaginärteils (27) des Rückkopplungssignals umfasst, wobei der dritte Multiplizierer (37) das Pulssignal mit dem Realteil des mit der Frequenz $\omega_0$ oszillierenden konjugiert komplexen Mischsignals multipliziert, und wobei der vierte Multiplizierer (38) das Pulssignal mit dem Imaginärteil des konjugiert komplexen Mischsignals der Frequenz $\omega_0$ multipliziert.

**14.** Pulsmodulator nach einem der vorstehenden Ansprüche, **dadurch gekennzeichnet, dass** der Pulsmodulator mit einer Abtastfrequenz $\omega_A$ betrieben wird, welche 2 bis 1000 mal höher ist als die Mischfrequenz $\omega_0$.

**15.** Pulsmodulator nach einem der vorstehenden Ansprüche, **dadurch gekennzeichnet, dass** der Pulsmodulator mit Hilfe eines digitalen Signalprozessors implementiert ist.

**16.** Ansteuerschaltung für einen mikromechanischen Resonator, welche mindestens einen Pulsmodulator nach einem der Ansprüche 1 bis 15 umfasst.

**17.** Ansteuerschaltung nach Anspruch 16, **dadurch gekennzeichnet, dass** das von dem mindestens einen Pulsmodulator erzeugte Pulssignal zur elektrostatischen Schwingungsanregung des Resonators verwendet wird.

**18.** Ansteuerschaltung nach Anspruch 16 oder 17, **dadurch gekennzeichnet, dass** die Mischfrequenz $\omega_0$ des Pulsmodulators einer Resonanzfrequenz des Resonators entspricht.

**19.** Frequenzgenerator zur Synthese eines Pulssignals mit vorgegebener Frequenz und Phase, welcher mindestens einen Pulsmodulator nach einem der Ansprüche 1 bis 15 umfasst.

**20.** Frequenzgenerator nach Anspruch 19 oder 20, **dadurch gekennzeichnet, dass** dem Pulsmodulator ein Bandpassfilter, vorzugsweise ein Quarz- oder Keramikfilter nachgeschaltet ist.

**EP 1 620 950 B1**

**21.** Verfahren zur Pulsmodulation eines komplexen Eingangssignals, **gekennzeichnet durch** folgende Schritte:

- Erzeugen eines Regelabweichungssignals aus der Differenz des komplexen Eingangssignals (x(t)) und eines Rückkopplungssignals (2);
- Umwandeln des Regelabweichungssignals in ein Regelsignal (7);
- Multiplizieren des Regelsignals (7) mit einem mit der Frequenz $\omega_0$ oszillierenden komplexen Mischsignal, wobei mindestens einer von Realteil (11) und Imaginärteil eines um $\omega_0$ heraufgemischten Regelsignals erzeugt wird;
- Quantisieren von mindestens einem von Realteil (11) und Imaginärteil des um $\omega_0$ heraufgemischten Regelsignals zum Erzeugen eines Pulssignals (y(t));
- Erzeugen des Rückkopplungssignals (2) ausgehend von dem Pulssignal (y(t)).

**22.** Verfahren nach Anspruch 21, **dadurch gekennzeichnet, dass** es sich bei dem Regelabweichungssignal, dem Regelsignal und dem Rückkopplungssignal jeweils um komplexe Signale handelt, die jeweils einen reellen Signalanteil sowie einen imaginären Signalanteil umfassen.

**23.** Verfahren nach Anspruch 21 oder Anspruch 22, **dadurch gekennzeichnet, dass** das Regelabweichungssignal in das Regelsignal umgewandelt wird, indem das Regelabweichungssignal integriert wird.

**24.** Verfahren nach einem der Ansprüche 21 bis 23, **dadurch gekennzeichnet, dass** der Realteil des Regelsignals mit dem Realteil des mit der Frequenz $\omega_0$ oszillierenden komplexen Mischsignals multipliziert und so ein erstes Ergebnissignal erzeugt wird, und dass der Imaginärteil des Regelsignals mit dem Imaginärteil des mit der Frequenz $\omega_0$ oszillierenden komplexen Mischsignals multipliziert und so ein zweites Ergebnissignal erzeugt wird.

**25.** Verfahren nach Anspruch 24, **dadurch gekennzeichnet, dass** zur Bestimmung des Realteils des heraufgemischten Regelsignals das erste Ergebnissignal und das zweite Ergebnissignal zu einem Summensignal addiert werden.

**26.** Verfahren nach Anspruch 25, **dadurch gekennzeichnet, dass** zum Erzeugen des Pulssignals eine Quantisierung des Summensignals durchgeführt wird.

**27.** Verfahren nach einem der Ansprüche 21 bis 26, **dadurch gekennzeichnet, dass** vor der Quantisierung von mindestens einem von Realteil und Imaginärteil des um $\omega_0$ heraufgemischten Regelsignals ein Rauschpegel hinzuaddiert wird.

**28.** Verfahren nach einem der Ansprüche 21 bis 27, **dadurch gekennzeichnet, dass** das Rückkopplungssignal erzeugt wird, indem das Pulssignal mit einem mit der Frequenz $\omega_0$ oszillierenden konjugiert komplexen Mischsignal multipliziert wird.

**29.** Verfahren nach einem der Ansprüche 21 bis 28, **dadurch gekennzeichnet, dass** das Pulssignal zur elektrostatischen Schwingungsanregung eines mikromechanischen Resonators verwendet wird.

**30.** Verfahren nach Anspruch 29, **dadurch gekennzeichnet, dass** die Mischfrequenz $\omega_0$ einer Resonanzfrequenz des mikromechanischen Resonators entspricht.

**31.** Computerprogrammprodukt, welches Mittel zur Ausführung der Verfahrensschritte gemäß einem der Ansprüche 21 bis 30 auf einem Computer, einem digitalen Signalprozessor oder dergleichen aufweist.

**Claims**

**1.** A pulse modulator for conversion of a complex input signal (x(t)) to a pulsed signal (y(t)), **characterized by**

- a subtraction stage (1) which produces a control error signal from the difference between the complex input signal (x(t)) and a feedback signal (2),
- a single conversion stage, which converts the control error signal to a control signal (7);
- a first multiplication stage (8), which multiplies the control signal (7) by a complex mixing signal oscillating at the frequency $\omega_0$, and thus produces at least one of a real part (11) and an imaginary part of a control signal which has been up-mixed by $\omega_0$;

**10**

- a quantization stage (12), which quantizes at least one of the real part and imaginary part of the control signal which has been up-mixed by $\omega_0$ and thus produces the pulsed signal ($y(t)$);
- a feedback unit, which uses the pulsed signal ($y(t)$) to produce the feedback signal (2) for the subtraction stage.

2. The pulse modulator as claimed in claim 1, **characterized in that** the pulse modulator has an in-phase signal path for processing of the real pant of the input signal, as well as a quadrature signal path for processing of the imaginary part of the input signal.

3. The pulse modulator as claimed in claim 1 or 2, **characterized in that** the control error signal, the control signal and the feedback signal are each complex signals, which each have a real signal component as well as an imaginary signal component.

4. The pulse modulator as claimed in one of the preceding claims, **characterized in that** the signal conversion stage has an integrator stage which integrates the control error signal and produces an integrated signal as the control signal.

5. The pulse modulator as claimed in claim 4, **characterized in that** the integrator stage has a first integrator for the in-phase signal path (14) and a second integrator for the quadrature signal path (15), with the first integrator integrating the real part of the control error signal, and with the second integrator integrating the imaginary part of the control error signal.

6. The pulse modulator as claimed in one of the preceding claims, **characterized in that** the signal conversion stage has an amplifier stage (6).

7. The pulse modulator as claimed in one of the preceding claims, **characterized in that** the first multiplication stage has a first multiplier (23) for the in-phase signal path and a second multiplier (33) for the quadrature signal path, with the first multiplier multiplying the real part (22) of the control signal by the real part of the complex mixing signal oscillating at the frequency $\omega_0$, and thus producing a first result signal (24), and with the second multiplier (33) multiplying the imaginary part (32) of the control signal by the imaginary part of the complex mixing signal oscillating at the frequency $\omega_0$, and thus producing a second result signal (34).

8. The pulse modulator as claimed in claim 7, **characterized by** an adder (25) which adds the first result signal (24) from the first multiplier and the second result signal (4) from the second multiplier to form a sum signal (35) in order to determine the real part of the up-mixed control signal.

9. The pulse modulator as claimed in claim 8, **characterized in that** the quantization stage quantizes the sum signal produced by the adder.

10. The pulse modulator as claimed in one of the preceding claims, **characterized in that** a noise level is added to the input signal to the quantization stage.

11. The pulse modulator as claimed in one of the preceding claims, **characterized in that** the quantization stage carries out binary quantization or ternary quantization of its respective input signal.

12. The pulse modulator as claimed in one of the preceding claims, **characterized in that** the feedback unit has a second multiplication stage (13), which multiplies the pulsed signal by a complex-conjugate mixing signal oscillating at the frequency $\omega_0$, and thus produces the feedback signal (2) down-mixed by $\omega_0$, for the subtractor.

13. The pulse modulator as claimed in claim 12, **characterized in that** the second multiplication stage has a third multiplier (37) for production of the real part (17) of the feedback signal and has a fourth multiplier (38) for production of the imaginary part (27) of the feedback signal, with the third multiplier (37) multiplying the pulsed signal by the real part of the complex-conjugate mixing signal oscillating at the frequency $\omega_0$, and with the fourth multiplier (38) multiplying the pulsed signal by the imaginary part of the complex-conjugate mixing signal at the frequency $\omega_0$.

14. The pulse modulator as claimed in one of the preceding claims, **characterized in that** the pulse modulator is operated at a sampling frequency $\omega_A$ which is 2 to 1000 times higher than the mixing frequency $\omega_0$.

15. The pulse modulator as claimed in one of the preceding claims, **characterized in that** the pulse modulator is implemented with the aid of a digital signal processor.

16. A drive circuit for a micromechanical resonator which has at least one pulse modulator as claimed in one of claims 1 to 15.

17. The drive circuit as claimed in claim 16, **characterized in that** the pulsed signal which is produced by the at least one pulse modulator is used for electrostatic oscillation stimulation of the resonator.

18. The drive circuit as claimed in claim 16 or 17, **characterized in that** the mixing frequency $\omega_0$ of the pulsed modulator corresponds to one resonant frequency of the resonator.

19. A frequency generator for synthesis of a pulsed signal at a predetermined frequency and with a predetermined phase, which has at least one pulse modulator as claimed in one of claims 1 to 15.

20. The frequency generator as claimed in claim 19 or 20, **characterized in that** the pulse modulator is followed by a bandpass filter, preferably a crystal or ceramic filter.

21. A method for pulse modulation of a complex input signal, **characterized by** the following steps:

- production of a control error signal from the difference between the complex input signal ($x(t)$) and a feedback signal (2);
- conversion of the control error signal to a control signal (7);
- multiplication of the control signal (7) by a complex mixing signal oscillating at the frequency $\omega_0$, with at least one of the real part (11) and imaginary part of a control signal, up-mixed by $\omega_0$, being produced;
- quantization of at least one of the real part (11) and imaginary part of the control signal, up-mixed by $\omega_0$, in order to produce a pulsed signal ($y(t)$);
- production of the feedback signal (2) from the pulsed signal ($y(t)$).

22. The method as claimed in claim 21, **characterized in that** the control error signal, the control signal and the feedback signal are each complex signals, which each have a real signal component as well as an imaginary signal component.

23. The method as claimed in claim 21 or claim 22, **characterized in that** the control error signal is converted to the control signal by integrating the control error signal.

24. The method as claimed in one of claims 21 to 23, **characterized in that** the real part of the control signal is multiplied by the real part of the complex mixing signal oscillating at the frequency $\omega_0$, and a first result signal is thus produced, and **in that** the imaginary part of the control signal is multiplied by the imaginary part of the complex mixing signal oscillating at the frequency $\omega_0$, and a second result signal is thus produced.

25. The method as claimed in claim 24, **characterized in that** the first result signal and the second result signal are added to form a sum signal in order to determine the real part of the up-mixed control signal.

26. The method as claimed in claim 25, **characterized in that** the sum signal is quantized in order to produce the pulsed signal.

27. The method as claimed in one of claims 21 to 26, **characterized in that** a noise level is added before the quantization of at least one of the real part and imaginary part of the control signal up-mixed by $\omega_0$.

28. The method as claimed in one of claims 21 to 27, **characterized in that** the feedback signal is produced by multiplying the pulsed signal by a complex-conjugate mixing signal oscillating at the frequency $\omega_0$.

29. The method as claimed in one of claims 21 to 28, **characterized in that** the pulsed signal is used for electrostatic oscillation stimulation of a micromechanical resonator.

30. The method as claimed in claim 29, **characterized in that** the mixing frequency $\omega_0$ corresponds to one resonant frequency of the micromechanical resonator.

31. A computer program product, which has means for carrying out the method steps as claimed in one of claims 21 to 30 on a computer, a digital signal processor or the like.

**Revendications**

1. Modulateur d'impulsions pour la transformation d'un signal d'entrée complexe (x/(t)) en un signal d'impulsions (y(t)), **caractérisé par** :

   - une étape de soustraction (1) qui à partir de la différence entre le signal d'entrée complexe (x(t)) et un signal de rétroaction (2) génère un signal de déviation ;
   - une étape de transformation de signal, qui transforme le signal de déviation en un signal de réglage (7) ;
   - une première étape de multiplication (8), qui multiplie le signal de réglage (7) par un signal de battement complexe, oscillant à la fréquence $\omega_0$ et génère de cette façon au moins l'une de la partie réelle (11) et de la partie imaginaire d'un signal de réglage modulé vers le haut de la valeur $\omega_0$,
   - une étape de quantification (12) quantifiant au moins l'une de la partie réelle (11) et de la partie imaginaire d'un signal de réglage modulé vers le haut de la valeur $\omega_0$, générant de cette façon le signal d'impulsions (y(t)) ;
   - une unité de rétroaction, qui à partir du signal d'impulsions (y(t)) génère le signal de rétroaction (2) pour l'étape de soustraction.

2. Modulateur d'impulsions selon la revendication 1, **caractérisé en ce que** le modulateur d'impulsions comprend un cheminement de signal en phase pour le traitement de la partie réelle du signal d'entrée, ainsi qu'un cheminement de signal en quadrature, pour le traitement de la partie imaginaire du signal d'entrée.

3. Modulateur d'impulsions selon la revendication 1 ou 2, **caractérisé en ce que** le signal de déviation, le signal de réglage et le signal de rétroaction sont respectivement des signaux complexes, comprenant chacun une partie réelle de signal et une partie imaginaire de signal.

4. Modulateur d'impulsions selon l'une quelconque des revendications précédentes, **caractérisé en ce que** l'étape de transformation de signal comprend une étape d'intégration, qui totalise le signal de déviation et qui en tant que signal de réglage génère un signal intégré.

5. Modulateur d'impulsions selon la revendication 4, **caractérisé en ce que** l'étape d'intégration comprend un premier intégrateur pour le cheminement de signal en phase (14) et un deuxième intégrateur pour la cheminement de signal en quadrature (15), le premier intégrateur totalisant la partie réelle du signal de déviation et le deuxième intégrateur totalisant la partie imaginaire du signal de déviation.

6. Modulateur d'impulsions selon l'une quelconque des revendications précédentes, **caractérisé en ce que** l'étape de transformation de signal comprend une étape d'amplification (6).

7. Modulateur d'impulsions selon l'une quelconque des revendications précédentes, **caractérisé en ce que** la première étape de multiplication comprend un premier multiplicateur (23) pour le cheminement de signal en phase et un deuxième multiplicateur (33) pour le cheminement de signal en quadrature, le premier multiplicateur multipliant la partie réelle (22) du signal de réglage par la partie réelle du signal de battement complexe oscillant à la fréquence $\omega_0$ et générant de cette façon un premier signal de résultat (24) et le deuxième multiplicateur (33) multipliant la partie imaginaire (32) du signal de réglage par la partie imaginaire du signal de battement complexe oscillant à la fréquence $\omega_0$ et générant de cette façon un deuxième signal de résultat (34).

8. Modulateur d'impulsions selon la revendication 7, **caractérisé par** un totalisateur (25), qui pour déterminer la partie réelle du signal de réglage modulé à la hausse additionne le premier signal de résultat (24) du premier multiplicateur et le deuxième signal de résultat (34) du deuxième multiplicateur en un signal total (35).

9. Modulateur d'impulsions selon la revendication 8, **caractérisé en ce que** l'étape de quantification quantifie le signal total fourni par le totalisateur.

10. Modulateur d'impulsions selon l'une quelconque des revendications précédentes, **caractérisé en ce qu'**un niveau de bruit est additionné au signal d'entrée de l'étape de quantification.

11. Modulateur d'impulsions selon l'une quelconque des revendications précédentes, **caractérisé en ce que** l'étape de quantification procède à une quantification binaire ou à une quantification ternaire de son signal d'entrée respectif.

12. Modulateur d'impulsions selon l'une quelconque des revendications précédentes, **caractérisé en ce que** l'unité de rétroaction comprend une deuxième étape de multiplication (13) qui multiplie le signal d'impulsions par un signal de battement complexe conjugué, oscillant à la fréquence $\omega_0$ et génère ainsi le signal de rétroaction (2) modulé à la baisse de la valeur $\omega_0$ pour le soustracteur.

13. Modulateur d'impulsions selon la revendication 12, **caractérisé en ce que** la deuxième étape de multiplication comprend un troisième multiplicateur (37) pour générer la partie réelle (17) du signal de rétroaction et un quatrième multiplicateur (38) pour générer la partie imaginaire (27) du signal de rétroaction, le troisième multiplicateur (37) multipliant le signal d'impulsion par la partie réelle du signal de battement complexe conjugué oscillant à la fréquence $\omega_0$ et le quatrième multiplicateur (38) multipliant le signal d'impulsions par la partie imaginaire du signal de battement complexe conjugué, oscillant à la fréquence $\omega_0$.

14. Modulateur d'impulsions selon l'une quelconque des revendications précédentes, **caractérisé en ce que** le modulateur d'impulsions est exploité à une fréquence de balayage $\omega_\Lambda$, qui est de 2 à 1000 fois supérieure à la fréquence de battement $\omega_0$.

15. Modulateur d'impulsions selon l'une quelconque des revendications précédentes, **caractérisé en ce que** le générateur d'impulsions est implémenté à l'aide d'un processeur numérique de signaux.

16. Circuit d'excitation pour un résonateur micromécanique, qui comprend au moins un modulateur d'impulsions selon l'une quelconque des revendications 1 à 15.

17. Circuit d'excitation selon la revendication 16, **caractérisé en ce qu'**on utilise le signal d'impulsions généré par le au moins un modulateur d'impulsions pour l'excitation électrostatique de l'oscillation du résonateur.

18. Circuit d'excitation selon la revendication 16 ou 17, **caractérisé en ce que** la fréquence de battement $\omega_0$ du modulateur d'impulsions correspond à une fréquence de résonance du résonateur.

19. Générateur de fréquences pour la synthèse d'un signal d'impulsions à fréquence et phase prédéfinies, qui comprend au moins un modulateur d'impulsions selon l'une quelconque des revendications 1 à 15.

20. Générateur de fréquences selon la revendication 19 ou 20, **caractérisé en ce que** le modulateur d'impulsions est monté en aval d'un filtre passe-bande, de préférence d'un filtre en quartz ou en céramique.

21. Procédé de modulation d'impulsions d'un signal d'entrée complexe, **caractérisé par** les étapes suivantes :

   - génération d'un signal de déviation à partir de la différence entre le signal d'entrée complexe (x(t)) et un signal de rétroaction (2) ;
   - transformation du signal de déviation en un signal de réglage (7) ;
   - multiplication du signal de réglage (7) par un signal de battement complexe oscillant à la fréquence $\omega_0$, au moins l'une d'entre la partie réelle (11) et la partie imaginaire du signal de réglage modulé à la hausse de la valeur de $\omega_0$ étant générée ;
   - quantification d'au moins l'une d'entre la partie réelle (11) et la partie imaginaire du signal de réglage modulé à la hausse de la valeur de $\omega_0$ pour générer un signal d'impulsions (y(t)) ;
   - génération du signal de rétroaction (2) à partir du signal d'impulsions (y(t)).

22. Procédé selon la revendication 21, **caractérisé en ce que** le signal de déviation, le signal de réglage et le signal de rétroaction sont respectivement des signaux complexes, comprenant chacun une partie réelle de signal et une partie imaginaire de signal.

23. Procédé selon la revendication 21 ou la revendication 22, **caractérisé en ce que** le signal de déviation est transformé en le signal de réglage par intégration du signal de déviation.

24. Procédé selon l'une quelconque des revendications 21 à 23, **caractérisé en ce que** la partie réelle du signal de réglage est multipliée par la partie réelle du signal de battement complexe oscillant à la fréquence $\omega_0$, pour générer de cette façon un premier signal de résultat et **en ce que** la partie imaginaire du signal de réglage est multipliée par la partie imaginaire du signal de battement complexe oscillant à la fréquence $\omega_0$, pour générer de cette façon un deuxième signal de résultat.

**25.** Procédé selon la revendication 24, **caractérisé en ce que** pour déterminer la partie réelle du signal de réglage modulé à la hausse, le premier signal de résultat et le deuxième signal de résultat sont additionnés en un signal total.

**26.** Procédé selon la revendication 25, **caractérisé en ce que** pour générer le signal d'impulsions, on procède à une quantification du signal total.

**27.** Procédé selon l'une quelconque des revendications 21 à 26, **caractérisé en ce qu'**avant la quantification d'au moins une partie réelle et une partie imaginaire du signal de réglage modulé à la hausse de la valeur $\omega_0$, on y ajoute un niveau de bruit.

**28.** Procédé selon l'une quelconque des revendications 21 à 27, **caractérisé en ce que** le signal de rétroaction est généré par multiplication du signal d'impulsions par un signal de battement complexe conjugué oscillant à la fréquence $\omega_0$.

**29.** Procédé selon l'une quelconque des revendications 21 à 28, **caractérisé en ce que** le signal d'impulsions est utilisé pour l'excitation électrostatique d'impulsions d'un résonateur micromécanique.

**30.** Procédé selon la revendication 29, **caractérisé en ce que** la fréquence de battement $\omega_0$ correspond à une fréquence de résonance du résonateur micromécanique.

**31.** Produit de programme informatique, comportant des moyens pour la réalisation des étapes de procédé selon l'une quelconque des revendications 21 à 30 sur un ordinateur, avec un processeur de signaux numérique ou similaire.

EP 1 620 950 B1

$x(t)$

$e^{-j\omega_o t}$ $\qquad$ $e^{+j\omega_o t}$

$z^{-1}$ $\quad$ $a$ $\quad$ $\mathcal{R}$

$y(t)$

Fig. 1

Fig. 2

Fig.3

Fig. 4

Fig. 5

Fig. 6

Fig. 8

20

Fig. 7

Fig. 9